# EUROPÄISCHE PATENTANMELDUNG

(11) **EP 1 124 265 A2**
(43) Veröffentlichungstag der Anmeldung: **16.08.2001**
(21) Anmeldenummer: 01101855.3
(22) Anmeldetag: 26.01.2001
(51) Int. Cl.: H01L 41/047, H01L 41/083

(54) **Piezoelektrischer Keramikkörper mit silberhaltigen Innenelektroden**

(30) Priorität: 12.02.2000 DE 10006352
(71) Anmelder: ROBERT BOSCH GMBH, 70442 Stuttgart (DE)
(72) Erfinder: Hammer, Marianne, 70563 Stuttgart (DE); Lindner, Friederike, 70839 Gerlingen (DE); Kuschel, Petra, 71272 Renningen (DE)

(57) **Zusammenfassung**

Es wird ein piezoelektrischer Keramikkörper (5) mit einer Mehrzahl von übereinander angeordneten Isolierschichten (12) mit einem piezoaktiven keramischen Material vorgeschlagen, wobei die Isolierschichten (12) zumindest bereichsweise durch Innenelektroden (13, 14) voneinander getrennt sind, von denen mindestens eine zumindest bereichsweise ein silberhaltiges Material aufweist. Das Material der silberhaltigen Innenelektrode (13, 14) weist weiter eine die Diffusion von Silber von der Innenelektrode (13, 14) in eine Isolierschicht (12) reduzierende oder inhibitierende Komponente, insbesondere eine keramische Komponente auf Basis einer PZT-Keramik, auf.

## Beschreibung

Die Erfindung betrifft einen piezoelektrischen Keramikkörper mit mindestens einer silberhaltigen Innenelektrode nach der Gattung des Hauptanspruches.

### Stand der Technik

Keramische Piezoaktoren, die aus einer Vielzahl von dünnen, keramischen piezoaktiven Schichten bestehen, die jeweils über eine Innenelektrodenschicht voneinander getrennt und darüber elektrisch kontaktierbar und ansteuerbar sind, sind vielfach bekannt. Dazu sei beispielsweise auf die Anmeldung DE 199 51 016.4 verwiesen.

Derartige Piezoaktoren bestehen beispielsweise im Wesentlichen aus einer PZT-Keramik, d.h. Pb(Ti_{X}Zr_{1-X})O₃ mit 0,4 < x < 0,6, in Form einer Vielzahl von zusammengesinterten, keramischen piezoaktiven Schichten aus dieser PZT-Keramik, die über dazwischen angebrachte Innenelektroden elektrisch in definierter Weise ansteuerbar sind und bei Anlegen einer äußeren Spannung über den inversen Piezoeffekt eine Dehnung oder Stauchung erfahren. Bei typischen Ansteuerspannungen von 100 bis 300 Volt liegt diese Längenänderung im Bereich von 0,1 bis 0,3 %.

Die Innenelektroden bei piezoelektrischen Keramikkörpern müssen einerseits aus Materialien bestehen, deren Schmelzpunkt über den für die Sinterung der Keramiken notwendigen Temperaturen liegt. Darüber hinaus müssen die Materialien der Innenelektroden oxidationsstabil sein, da die Sinterung der als Aktoren dienenden Isolationsschichten und damit des gesamten piezoelektrischen Keramikkörpers unter Sauerstoff oder Luft ausgeführt wird. Um diese Oxidationsstabilität zu gewährleisten, werden üblicherweise Edelmetalle oder Edelmetalllegierungen als Innenelektrodenmaterialien eingesetzt.

Ein häufig verwendetes Innenelektrodenmaterial ist Platin, was jedoch sehr teuer ist, so dass vielfach auf Silber-Palladium-Legierungen ausgewichen wird, die eine typische Zusammensetzung von 70 Masse% Silber und 30 Masse% Palladium aufweisen. Diese Zusammensetzung gewährleistet einen für die Sinterung ausreichend hohen Schmelzpunkt.

Nachteilig beim Einsatz von Silber in den Innenelektroden ist die Tatsache, dass es beim Sintern in einem Cofiring-Prozess zu einer Diffusion von Silber aus den Elektroden in die benachbarten Isolierschichten kommt. Dies führt zu einer unerwünschten Beeinflussung der elektromechanischen Eigenschaften des piezoelektrischen Keramikkörpers, da das eindiffundierende Silber beispielsweise auf die Pb-Plätze der PZT-Piezokeramik eingebaut wird. Nachteilig an dieser unerwünschten Diffusion ist weiterhin, dass sich beim Eindiffundieren großer Mengen von Silber in die PZT-Keramik nach Erreichen einer Silber-Sättigung Silber-Sekundärphasen ausbilden, was den spezifischen elektrischen Widerstand des an sich elektrisch isolierenden PZT-Materials verringert. Dadurch kann es zu unerwünschten elektrischen Durchschlägen kommen.

Nachteilig an den bekannten Silber-Palladium-Legierungen als Innenelektrodenmaterial ist schließlich, dass der Anteil von Palladium mit ca. 30 Masse% immer noch relativ hoch ist, was auch dieses Innenelektrodenmaterial relativ teuer macht. Eine wünschenswerte Reduktion des Palladium-Gehaltes zieht jedoch eine weitere Erhöhung des Silber-Gehaltes nach sich, was die erwähnten Nachteile aufgrund von unerwünschten Diffusionseffekten noch verstärkt.

### Vorteile der Erfindung

Der erfindungsgemäße piezoelektrische Keramikkörper hat gegenüber dem Stand der Technik den Vorteil, dass eine Diffusion von Silber aus den Innenelektroden in die benachbarten Isolierschichten vermindert oder unterdrückt wird. Somit verbleibt das dem Innenelektrodenmaterial zugesetzte Silber im Wesentlichen in der Elektrode, so dass eine negative Beeinflussung der Eigenschaften des piezoelektrischen keramischen Materials, beispielsweise einer PZT-Keramik, durch das Eindiffundieren von Silber deutlich reduziert wird.

Vorteilhafte Weiterbildungen der Erfindung ergeben sich aus den in den Unteransprüchen genannten Maßnahmen.

So ist es besonders vorteilhaft, wenn die die Diffusion von Silber reduzierende oder inhibitierende Komponente des Innenelektrodenmaterials eine keramische Komponente, insbesondere eine piezoelektrische keramische Komponente wie eine PZT-Keramik ist. Auf diese Weise kann in einfacher Weise eine Anpassung der mechanischen Eigenschaften, insbesondere hinsichtlich Temperaturverhalten und Wärmeausdehnung, des Materials der Innenelektroden an die benachbarten Isolierschichten erfolgen, die üblicherweise aus PZT-Keramiken bestehen. Zudem wird auf diese Weise die Haftung zwischen den Innenelektroden und den benachbarten Isolierschichten verbessert.

Insgesamt entsteht somit vorteilhaft eine Reduktion des Ausschusses im Herstellungsprozess, da die genannten Effekte das Auftreten von Delaminationen oder Rissen in dem erzeugten piezoelektrischen Keramikkörper während des Sinterns und nach dem Sintern unterdrücken.

Darüber hinaus ist es vorteilhaft, wenn der Anteil der die Diffusion von silberreduzierenden oder inhibitierenden Komponente 50 Volumenprozent, bezogen auf das Gesamtvolumen des Materials der Innenelektrode, nicht überschreitet. Dadurch ist sichergestellt, dass stets eine ausreichend hohe elektrische Leitfähigkeit der Innenelektroden erhalten bleibt.

Der optimale Wert für den Anteil der die Diffusion von silberreduzierenden oder inhibitierenden Komponente, beispielsweise der zugesetzten PZT-Keramik, ist vom Fachmann im Einzelfall anhand einfacher Vorversuche festzustellen, da dieser Anteil stark von den Korngrößen des eingesetzten Metall- und Keramikpulvers zur Herstellung der Isolierschichten bzw. der Innenelektroden abhängig ist.

Im Übrigen hat es sich als sehr vorteilhaft erwiesen, wenn die die Diffusion von Silber reduzierende oder inhibitierende Komponente des Innenelektrodenmaterials zusätzlich Seltenerdmetalle wie Lanthan oder Neodym, Nebengruppenelemente wie Niob, Alkalimetalle wie Lithium, Natrium oder Kalium, oder Erdalkalielemente wie Strontium enthält. Diese Materialien haben eine günstigen Einfluss auf die charakteristischen physikalischen Größen des erzeugten piezoelektrischen Vielschichtaktors und können sowohl den Isolierschichten als auch dem Material der Innenelektroden zugesetzt werden.

Bevorzugt werden die Seltenerdmetalle, die Nebengruppenelemente, die Alkalimetalle und/oder die Erdalkalimetalle dem Material der Innenelektrode und/oder dem Material der Isolierschichten in Form eines Dotierstoffes mit einem Anteil von weniger als 8 mol%, insbesondere weniger als 5 mol%, bezogen auf das Material der Innenelektrode bzw. der Isolierschicht zugesetzt.

Die zugesetzten, die Diffusion von Silber reduzierenden oder inhibitierenden Komponenten sind schließlich nicht auf piezoelektrische Schichten aus einem PZT-artigen Material beschränkt.

### Zeichnungen

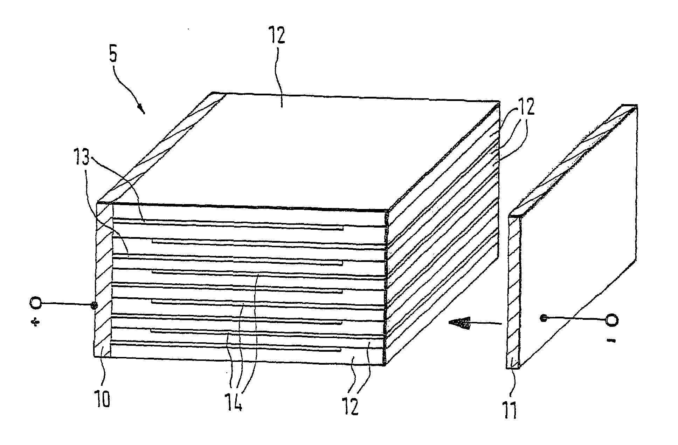

Die Erfindung wird anhand der Zeichnung und in der nachfolgenden Beschreibung näher erläutert. Die einzige Figur zeigt einen piezoelektrischen Keramikkörper in Form eines piezokeramischen Aktors mit einer Schichtfolge von piezoaktiven Isolierschichten und silberhaltigen Innenelektrodenschichten.

### Ausführungsbeispiele

Die Figur zeigt einen an sich aus DE 199 51 016.4 bekannten Aufbau eines piezoelektrischen Keramikkörpers 5 in Form eines Quaders mit einer Vielzahl von gesinterten Isolierschichten 12 aus einer an sich bekannten, piezoaktiven PZT-Keramik, die über gesinterte Innenelektroden 13, 14 in Form von dünnen Schichten bereichsweise jeweils voneinander getrennt sind. Die PZT-Keramik hat beispielsweise die Zusammensetzung Pb(TiₓZr₁-ₓ)O₃ mit 0,4 < x < 0,6. Die Dicke der Isolierschicht 12 beträgt beispielsweise 50 Mikrometer bis 130 Mikrometer bei einer typischen Anzahl von 300 bis 600; die Dicke der Innenelektroden 13, 14 liegt bevorzugt zwischen 500 Nanometer und 5 Mikrometer, insbesondere bei 1 bis 2 Mikrometer.

Die Stirnseiten des Keramikkörpers 5 sind weiter durch zwei gegenüberliegende, beispielsweise metallische, flächig aufgebrachte Außenelektroden 10, 11 in an sich bekannter Weise kontaktiert, wobei die erste Außenelektrode 10 an der zugeordneten Stirnseite des Quaders die ersten Innenelektroden 13 kontaktiert und die zweite Außenelektrode 11 an der zugeordneten Stirnseite des Quaders die zweiten Innenelektroden 14 kontaktiert. Über die Außenelektroden 10, 11 sind die Innenelektroden 13, 14 mit einer Feldstärke beaufschlagbar, die typischerweise zwischen 1 kV/mm und 3 kV/mm liegt und in dem Keramikkörper 5 über den inversen piezoelektrischen Effekt zu einer Dehnung oder Stauchung der Isolierschichten 12 in Richtung der Flächennormalen der Isolierschichten 12 führt. Die Innenelektroden 13, 14 bilden somit die Platten eines Plattenkondensators mit den Isolierschichten 12 als Dielektrikum. Zur Herstellung des Keramikkörpers 5 werden zunächst in an sich bekannter Weise keramische Grünfolien hergestellt, die die späteren Isolierschichten 12 bilden sollen. Diese werden dann bereichsweise, entsprechend der in der Figur dargestellten Weise, einseitig mit einer weiteren Folie versehen, die eine spätere Innenelektrode 13, 14 bilden soll. Alternativ kann das die spätere Innenelektroden 13, 14 bildende Material jedoch auch mittels Siebdruck bereichsweise auf die keramischen Grünfolien aufgedruckt werden. Anschließend werden diese Grünfolienpaare bzw. die bedruckten Grünfolien dann derart abwechselnd um 180° gegeneinander gedreht gestapelt, dass eine periodische Abfolge von Isolierschicht 12, erste Innenelektrode 13, Isolierschicht 12, zweite Innenelektrode 14, Isolierschicht 12, erste Innenelektrode 13, usw. entsteht. Schließlich wird der derart erhaltene Grünkörper in einer Matrize gepresst bzw. laminiert und anschließend bei Temperaturen zwischen 1000°C und 1200°C gesintert, so dass der Keramikkörper 5 entsteht.

Nach dem Sintern wird der erhaltene Keramikkörper 5 dann üblicherweise außen geschliffen und auf zwei gegenüberliegenden Stirnflächen mit den Außenelelektroden 10, 11 kontaktiert. Aufgrund der abwechselnd jeweils nicht bis zu den Stirnseiten des Keramikkörpers 5 reichenden Innenelektroden 13, 14 kontaktiert somit die erste Außenelektrode 10 lediglich die ersten Innenelektroden 13 und die zweite Außenelektrode 11 lediglich die zweiten Innenelektroden 14.

Als Material der Innenelektroden 13, 14 ist im erläuterten Ausführungsbeispiel vorgesehen, dass diese aus einer Silber-Palladium-Legierung bestehen, der zusätzlich eine piezoelektrische keramische Komponente zugesetzt ist. Diese piezoelektrische keramische Komponente ist im konkreten Beispiel eine PZT-Keramik, die bevorzugt die gleiche Zusammensetzung hat, wie die der benachbarten Isolierschichten 12. Insgesamt beträgt der Anteil der piezoelektrischen keramischen Komponente in den Innenelektroden 13, 14 maximal 50 Volumenprozent bezogen auf das Gesamtvolumen des Materials der Innenelektroden 13, 14. Bevorzugt liegt der Anteil der PZT-Keramik in den Innenelektroden 13, 14 zwischen 10 Volumenprozent und 30 Volumenprozent. Als Silber-Palladium-Legierung wird zweckmäßigerweise eine Legierung eingesetzt, deren Palladiumgehalt möglichst niedrig ist. Bevorzugt sind Legierungen mit einem Anteil von weniger als 30 Masse% Palladium, insbesondere weniger als 20 Masse%.

Als Material für die Isolierschichten 12 und als piezoelektrische keramische Komponente in den Innenelektroden 13, 14 eignet sich bevorzugt eine PZT-Keramik (Blei-Zirkonat-Titanat-Keramik) der zusätzlich Dotierstoffe in einer Größenordnung von 2 mol% bis 8 mol% zugesetzt sind. Als Dotierstoffe eignen sich wie Seltenerdmetalle Lanthan oder Neodym, Nebengruppenelemente wie Niob, Tantal, Eisen oder Nickel, Alkalimetalle wie Natrium, Kalium oder Lithium oder Erdalkalielemente wie Strontium.

Im Einzelnen bestehen die Innenelektroden 14, 15 im erläuterten Beispiel aus einer elektrisch leitenden AgPd-Legierung im Massenverhältnis 85:15. Dieser AgPd-Legierung ist ein keramisches PZT-Material im Anteil von 20 Volumenprozent zugesetzt, das als Dotierstoff zusätzlich mit 2 mol% Sr(K_{0,25}Nb_{0,75})O₃ versetzt worden ist. Insgesamt ist diese Zusammensetzung der Innenelektroden 14, 15 bei Temperaturen unterhalb 1100°C sinterbar. Das Innenelektrodenmaterial wird dabei zunächst in an sich bekannter Weise als Paste hergestellt.

## Patentansprüche

1. Piezoelektrischer Keramikkörper mit einer Mehrzahl von übereinander angeordneten Isolierschichten (12) mit einem piezoaktiven keramischen Material, die zumindest bereichsweise durch Innenelektroden (13, 14) voneinander getrennt sind, wobei mindestens eine Innenelektrode (13, 14) zumindest bereichsweise ein silberhaltiges Material aufweist, dadurch gekennzeichnet, daß zumindest das Material der silberhaltigen Innenelektrode (13, 14) eine die Diffusion von Silber von der Innenelektrode (13, 14) in eine Isolierschicht (12) reduzierende oder inhibitierende Komponente aufweist.

2. Piezoelektrischer Keramikkörper nach Anspruch 1, dadurch gekennzeichnet, daß die die Diffusion von Silber reduzierende oder inhibitierende Komponente eine keramische Komponente, insbesondere eine piezoelektrische keramische Komponente, enthält.

3. Piezoelektrischer Keramikkörper nach Anspruch 2, dadurch gekennzeichnet, daß die keramische Komponente eine PZT-Keramik, insbesondere Pb(TiₓZr₁₋ₓ)O₃ mit 0,40 < x < 0,60, ist.

4. Piezoelektrischer Keramikkörper nach Anspruch 1, dadurch gekennzeichnet, daß das silberhaltige Material eine AgPd-Legierung als Hauptbestandteil aufweist.

5. Piezoelektrischer Keramikkörper nach Anspruch 4, dadurch gekennzeichnet, daß die AgPd-Legierung mindestens 70 Masse% Ag enthält.

6. Piezoelektrischer Keramikkörper nach mindestens einem der vorangehenden Ansprüche, dadurch gekennzeichnet, daß die die Diffusion von Silber reduzierende oder inhibitierende Komponente mit einem Anteil von maximal 50 Vol%, bezogen auf das Gesamtvolumen des Materials der Innenelektrode (13, 14), vorliegt.

7. Piezoelektrischer Keramikkörper nach mindestens einem der vorangehenden Ansprüche, dadurch gekennzeichnet, daß die die Diffusion von Silber reduzierende oder inhibitierende Komponente Seltenerdmetalle wie La oder Nd, Nebengruppenelemente wie Nb, Ta, Fe oder Ni, Alkalimetalle wie Li, Na und/oder K, oder Erdalkalimetalle wie Sr enthält.

8. Piezoelektrischer Keramikkörper nach Anspruch 7, dadurch gekennzeichnet, daß die Seltenerdmetalle, die Nebengruppenelemente, die Alkalimetalle und/oder die Erdalkalimetalle als Dotierstoffe mit einem Anteil von weniger als 8 mol%, bezogen auf das Material der Innenelektrode (13, 14) eingesetzt sind.

9. Piezoelektrischer Keramikkörper nach mindestens einem der vorangehenden Ansprüche, dadurch gekennzeichnet, daß die Innenelektroden (13, 14) elektrisch leitfähig sind und aus einer AgPd-Legierung bestehen, der gegebenenfalls mit Seltenerdmetallen und/oder Nebengruppenelementen und/oder Alkalimetallen und/oder Erdalkalimetallen modifizierte PZT-Keramik zugesetzt ist.
